# FASCICULE DE BREVET EUROPEEN

(11) **EP 2 702 363 B1**
(45) Date de publication et mention de la délivrance du brevet: **07.01.2015**
(21) Numéro de dépôt: 12734961.1
(22) Date de dépôt: 08.06.2012
(51) Int. Cl.: G01D 5/24, G01R 27/26

(54) **CIRCUIT INTÉGRÉ DE MESURE CAPACITIVE A PONT FLOTTANT**
INTEGRIERTE SCHALTUNG ZUR KAPAZITIVEN MESSUNG MIT EINER NICHT GEERDETEN BRÜCKE
INTEGRATED CIRCUIT FOR CAPACITIVE MEASUREMENT INCLUDING A FLOATING BRIDGE

(30) Priorité: 16.06.2011 FR 1155288
(43) Date de publication de la demande: 05.03.2014
(73) Titulaire: Nanotec Solution, 30900 Nîmes (FR)
(72) Inventeur: BLONDIN, Christophe, F-30900 Nîmes (FR); NEEL, Christian, F-30900 Nîmes (FR); ROZIERE, Didier, F-30900 Nîmes (FR)
(74) Mandataire: Pontet Allano & Associes
(86) Numéro de dépôt international: PCT/FR2012/051290
(87) Numéro de publication internationale: WO 2012/172241

(56) Documents cités:
- FR-A1- 2 608 751
- FR-A1- 2 756 048
- FR-A1- 2 893 711

## Description

### Domaine technique

La présente invention concerne un dispositif électronique de mesure capacitive à pont flottant réalisable sous la forme d'un circuit intégré.

Le domaine de l'invention est plus particulièrement mais de manière non limitative celui des dispositifs électroniques de mesure et de détection.

### Etat de la technique antérieure

Les interfaces tactiles ou sans contact de systèmes portables tels que des téléphones, des smartphones, des tablettes, des ordinateurs, ... sont fréquemment basées sur des techniques de mesure capacitive.

Selon ces techniques, l'écran ou l'appareil est pourvu d'électrodes, éventuellement transparentes. Lorsqu'un objet tel qu'un doigt arrive à proximité de ces électrodes, il se crée un couplage électrique de type capacitif entre cet objet qui représente une masse électrique, et les électrodes. La mesure de ce couplage capacitif permet ainsi de localiser l'objet.

L'évolution vers des interfaces sans contact pour lesquelles il faut détecter et localiser des objets à des distances relativement importantes de la surface de l'interface nécessite le développement de systèmes de détection capacitive de très grande sensibilité.

Le document FR2608751 décrit un dispositif de mesure capacitive selon l'état de la technique.

La technique de mesure capacitive « en pont flottant », développée initialement pour des applications de mesure de très grande précision, s'avère particulièrement bien adaptée à ce type d'applications.

Cette technique est par exemple décrite dans le document FR 2 756 048 de Rozière. Elle permet d'éliminer toutes les capacités parasites qui apparaissent dans des méthodes de mesure capacitive plus classiques entre les électrodes et leur environnement. Dans la mesure où ces capacités parasites, par principe inconnues et fluctuantes, se superposent à la capacité à mesurer entre un objet et les électrodes, elles limitent fortement la sensibilité et la précision de mesure des méthodes classiques.

Pour cela, une partie de l'électronique, comprenant les électrodes de détection et les premiers étages de l'électronique de mesure les plus sensibles, sont rendus flottants. Leur potentiel électrique de référence, ou potentiel de garde, est rendu oscillant par rapport à la masse générale du système par exemple au moyen d'un oscillateur qui relie la masse et la garde. Ainsi, aucune partie de l'électronique des étages sensibles n'est à la masse et il ne peut pas se créer de capacités parasites vers la masse.

Pour pouvoir mettre en oeuvre une technique de mesure capacitive dans un appareil portable tel qu'un téléphone ou une tablette, il est impératif de pouvoir réaliser l'électronique associée sous la forme d'un circuit intégré de faible encombrement et de faible consommation.

On sait réaliser les systèmes de mesure telles que divulguées dans FR 2 756 048 sous la forme de circuits imprimés ou hybrides avec des composants discrets. Par contre, les modes de réalisation décrits dans FR 2 756 048 ne peuvent pas être réalisés sous la forme d'un circuit intégré unique.

Un problème provient du fait que l'électronique comprend deux parties distinctes, avec des potentiels de référence distincts et oscillants l'un par rapport à l'autre. Cela génère les contraintes suivantes :
- les deux parties ne doivent pas se parasiter mutuellement, et en particulier les éléments à la masse ne doivent pas parasiter les éléments flottants ;
- le transfert des signaux entre les parties flottantes et à la masse nécessite des composants de découplage tels que des selfs de choc ou des optocoupleurs qui ne sont pas intégrables ;
- les alimentations électriques de la partie flottante doivent être générées ou transférées à partir de sources d'alimentation à la masse, ce qui nécessite de nouveau des composants de découplage (selfs de choc, convertisseurs DC/DC) difficilement intégrables.

On connaît le document FR 2 893 711 de Rozière qui divulgue un dispositif de mesure capacitive par pont flottant basé sur un circuit intégré. Toutefois, dans ce cas c'est tout le circuit intégré qui est alimenté en mode flottant, ou en d'autres termes au potentiel de garde. Il est donc nécessaire de rajouter des composants externes pour réaliser l'interfaçage avec l'électronique référencée à la masse, qui est donc également externe au circuit intégré de mesure. En outre, une partie au moins du circuit imprimé sur lequel il est fixé doit être également référencée au potentiel de garde.

Plus généralement, dès lors qu'on met en oeuvre une électronique capacitive avec une garde servant à minimiser ou éliminer des capacités parasites, il est nécessaire de séparer la zone à la garde du reste de l'électronique qui est susceptible de générer des capacités de fuite. Et dans tous les cas cette contrainte pose des difficultés d'intégration.

Le but de la présente invention est de proposer un dispositif électronique de mesure capacitive à garde, réalisable sous la forme d'un circuit intégré unique référencé à la masse, de telle sorte à pouvoir être aisément inséré sur un circuit électronique classique.

### Exposé de l'invention

Cet objectif est atteint avec un dispositif de mesure capacitive comprenant :
- un premier système électronique, référencé électriquement à un potentiel de garde, et apte à être relié à des électrodes capacitives,
- un second système électronique, référencé électriquement à un potentiel de masse, et relié audit premier système électronique par des moyens de liaison, et
- des moyens d'excitation reliés respectivement auxdits potentiels de garde et de masse de telle sorte à imposer entre ces potentiels une différence de tension alternative,
caractérisé en ce qu'il comprend en outre un circuit intégré, référencé à la masse, comprenant :
- une première zone d'implantation, référencée au potentiel de garde et dans laquelle est implémenté ledit premier système électronique, et
- une seconde zone d'implantation, référencée au potentiel de masse, et dans laquelle est implémenté ledit second système électronique.

Bien entendu, le terme « relié » doit être interprété dans le sens où des composants reliés entre eux peuvent être reliés directement, au travers d'une liaison électrique directe, ou reliés par l'intermédiaire de composants électriques ou électroniques additionnels.

La définition des potentiels de garde et de masse est bien entendu non limitative, le potentiel de masse pouvant également être flottant ou variable par rapport à une autre référence telle que la terre.

Le potentiel de masse peut par exemple correspondre au potentiel de référence de l'électronique à laquelle est relié le dispositif selon l'invention, et/ou le potentiel de référence d'une source de tension alimentant le circuit intégré.

Suivant un aspect avantageux de l'invention, la partie référencée au potentiel de garde du dispositif selon l'invention peut être essentiellement contenue dans le circuit intégré, qui est lui-même référencé et alimenté par des sources de tensions référencées au potentiel de masse. Ainsi, son intégration dans un système électronique en général en est grandement facilitée, et les contraintes liées à la présence de la partie électronique référencée au potentiel de garde sont minimisées.

Le dispositif selon l'invention peut comprendre en outre :
- une surface de blindage électriquement reliée au potentiel de garde, et disposée de telle sorte à couvrir au moins en partie et au moins selon un côté la surface de la première zone d'implantation ;
- une surface de blindage électriquement reliée au potentiel de garde, et disposée de telle sorte à couvrir au moins en partie et au moins selon un côté la surface des premières et secondes zones d'implantation.

La surface de blindage peut être interne au boîtier du circuit intégré. Elle peut être réalisée au niveau du substrat du ou des composant(s) implémentant les fonctions électroniques (chips) contenus dans le boîtier du circuit intégré. Elle peut également être externe au boîtier du circuit intégré et réalisée au niveau du circuit imprimé sur lequel est soudé ce boîtier.

Cette surface de blindage est un élément important pour le bon fonctionnement du circuit intégré. En effet, le premier système électronique référencé au potentiel de garde, ou au moins ses parties les plus sensibles, doivent être protégés des perturbations telles que des capacités parasites qui peuvent se constituer avec des éléments référencés au potentiel de masse (qui est également le potentiel de la cible que les électrodes capacitives doivent détecter). C'est pour cette raison que dans les dispositifs de l'art antérieur, la partie référencée au potentiel de garde est toujours réalisée sous la forme de composants distincts séparés des composants référencés à la masse.

A l'inverse, il a été reconnu dans le cadre de l'invention que le fait de blinder le circuit intégré avec un blindage référencé au potentiel de garde protège efficacement le premier système électronique référencé à la garde des perturbations de son environnement, et ne perturbe pas notablement le second système électronique référencé à la masse, qui comprend pour l'essentiel des composants numériques et peu sensibles.

Suivant des modes de réalisation, le circuit intégré peut comporter :
- deux puces distinctes comprenant respectivement les première et seconde zones d'implantation, intégrées dans un même boîtier, ou
- une puce comprenant sur un même substrat les première et seconde zones d'implantation.

Le circuit intégré peut comporter au moins une puce réalisée en mettant en oeuvre au moins l'une des technologies suivantes : CMOS, silicium sur isolant (SOI).

La technologie SOI (silicium sur isolant) permet de réaliser des isolations électriques entre parties d'un circuit par exemple à des potentiels de référence différents grâce à des couches d'oxyde de silicium, isolantes à l'électricité.

Dans le cadre de la technologie CMOS, une isolation électrique ne peut être obtenue que par l'intermédiaire de zones de déplétion créées entre des parties du substrat dopées P et des parties du substrat dopées N, polarisées en sens inverse (ce qui a pour effet de bloquer la jonction P-N). Ainsi, la mise en oeuvre de l'invention en utilisant cette technologie, par ailleurs courante et de coût relativement modéré, pose des contraintes particulières et nécessite de trouver une architecture permettant une répartition des potentiels électriques flottants et non flottants compatible avec les contraintes d'isolation.

La puce peut être réalisée en mettant en oeuvre une technologie CMOS à caissons multiples.

La puce peut en particulier être réalisée en mettant en oeuvre une technologie CMOS à triples caissons, comportant :
- un substrat de dopage P, relié au potentiel de garde,
- un premier caisson de dopage N,
- deux caissons de dopage N et P inclus dans le premier caisson, et correspondant chacun à l'une des première et seconde zones d'implantation.

Le circuit intégré peut être réalisé en mettant en oeuvre au moins l'une des technologies suivantes :
- assemblage d'une ou plusieurs puces juxtaposées dans un boîtier,
- empilement en 3D de puces (« chip level packaging »),
- connexions directes de puces (« flip chip »).

L'empilement en 3D des puces correspond par exemple aux techniques dites de « chip level packaging » dans lesquelles des puces sont superposées ou empilées. Elles peuvent alors être connectées par exemple par des connections traversantes (« TSV, through Silicon Via »).

Dans les techniques de connexions directes (« flip chip »), les puces ou ensembles de puces sont placées directement sur le circuit imprimé, ou soudées directement à ce dernier, par exemple au moyen de matrices de plots.

Le circuit intégré peut comprendre en outre (i) des premiers éléments de connexion permettant de relier le premier système électronique à des électrodes capacitives et/ou à des éléments au potentiel de garde, (ii) des seconds éléments de connexion permettant d'une part de relier le second système électronique à une électronique de traitement externe, et d'autre part d'alimenter ledit second système électronique, lesquels premiers et seconds éléments de connexion étant séparés par au moins un élément de connexion relié au potentiel de garde.

De manière générale, les connexions internes au circuit intégré, et externes entre ce circuit intégré et l'extérieur, doivent être agencées de telle sorte à éviter les couplages capacitifs entre éléments sensibles de la partie référencée au potentiel de garde et éléments référencés au potentiel de masse. Pour cela, on peut intercaler judicieusement des connexions au potentiel de garde, et optimiser la disposition et la géométrie des connexions.

Le fait que les parties référencées respectivement au potentiel de garde et au potentiel de masse soient intégrées pour l'essentiel dans un même circuit intégré est un avantage de l'invention, car il permet une optimisation des couplages lors de la conception du circuit intégré, indépendamment de l'environnement de son utilisation ultérieure.

Le circuit intégré peut comprendre en outre des moyens pour générer au moins une alimentation référencée au potentiel de garde.

Ainsi, il n'est pas nécessaire de générer une alimentation référencée au potentiel de garde à l'extérieur du circuit intégré, et la partie au potentiel de garde de l'électronique peut être essentiellement limitée au circuit intégré.

Le transfert d'une source d'alimentation continue entre la partie au potentiel de masse et la partie au potentiel de garde pose un problème particulier car il nécessite des moyens de liaison fonctionnant à basses fréquences, tels que des inductances qui sont très pénalisantes en termes d'encombrement.

Suivant des modes de réalisation, le circuit intégré peut comprendre en outre :
- une source de tension d'alimentation alternative référencée au potentiel de masse, dont le circuit se referme au travers des moyens d'excitation, et
- des moyens de redressement et de filtrage, reliés en entrée respectivement à ladite source de tension d'alimentation alternative et au potentiel de garde, de telle sorte à générer en une sortie une tension d'alimentation référencée audit potentiel de garde par redressement d'une tension aux bornes de la source de tension d'alimentation alternative.

On utilise ainsi une source de tension d'alimentation alternative référencée au potentiel de masse, donc du côté où la puissance est disponible.

Le circuit électrique de la source de tension d'alimentation alternative se referme au travers des moyens d'excitation, ou en d'autres termes le courant de cette source circule au travers de ces moyens d'excitation.

Le circuit de la source de tension d'alimentation alternative, qui est utilisée pour générer une tension d'alimentation et donc une puissance référencée au potentiel de référence, peut ainsi être refermé entre le potentiel de garde et le potentiel de masse, sans moyens de liaison supplémentaires, et sans court-circuiter les deux potentiels de référence.

Cette configuration est possible car les moyens d'excitation, quelle que soit leur configuration, se comporte sensiblement comme un générateur de tension parfait, appelé également générateur de Thévenin. Ce générateur impose une différence de tension alternative entre les potentiels de masse et de garde, ce qui permet de les maintenir flottants l'un par rapport à l'autre, tout en présentant une impédance très faible pour le courant d'alimentation. Ce résultat ne pourrait pas être obtenu sans la présence des moyens d'excitation.

Les moyens de redressement et de filtrage peuvent être conçus de telle sorte à ne comprendre que des composants intégrables, tels que des capacités et des moyens de commutation passifs (diodes, ...) ou actifs (« switchs » ou commutateurs à base de transistors, ...).

Ils peuvent être réalisés sous toute forme compatible, telle que par exemple selon un principe de redresseur simple avec une diode, ou de redresseur doubleur de tension de Schenkel.

Suivant des modes de réalisation, les moyens d'excitation du dispositif selon l'invention peuvent comprendre en outre l'un des ensembles de composants suivants :
- un buffer suiveur de tension, référencé au potentiel de masse et excité par un oscillateur référencé au potentiel de garde.
- un oscillateur référencé au potentiel de masse.

Dans les deux cas, la puissance des moyens d'excitation est fournie par des alimentations référencées au potentiel de masse. La mise en oeuvre du buffer permet de disposer d'un oscillateur référencé au potentiel de garde, de faible consommation et également utilisable comme excitation et/ou synchronisation dans le premier système électronique lors des mesures capacitives.

Suivant des modes de réalisation, Les moyens de liaison peuvent comprendre des capacités en série.

En effet, afin de transférer des signaux numériques ou analogiques entre les parties à des potentiels de référence différents, il est nécessaire de prévoir des moyens de découplage, selon une technologie qui se prête bien à une réalisation sous forme de circuit intégré. Dans les dispositifs de l'art antérieur tels que par exemple décrits dans FR 2 893 711, il est souvent fait usage d'inductances, qui ne sont pas intégrables.

Suivant des modes de réalisation, le système premier électronique peut comprendre des moyens de scrutation permettant d'interroger séquentiellement des électrodes capacitives pour en mesurer la capacité.

On peut ainsi mesurer un grand nombre d'électrodes avec une seule chaîne d'acquisition.

Le dispositif selon l'invention peut comprendre en outre des moyens de communication avec des dispositifs similaires lui permettant de fonctionner selon un mode maître ou esclave, selon lequel :
- les moyens d'excitation d'un dispositif configuré en mode maître imposent une différence de tension alternative similaire entre les potentiels de garde et de masse de dispositifs configurés en mode esclave, et
- les moyens d'excitation de dispositifs configurés en mode esclave sont au moins en partie désactivés.

Il est ainsi possible en utilisant plusieurs circuits intégrés identiques ou similaires configurés en mode maître-esclave (ou synchronisés) d'adresser un plus grand nombre d'électrodes que ce qui est atteignable avec un seul circuit intégré. En outre, les électrodes sont toutes référencées au même potentiel de garde, ce qui est essentiel pour la qualité des mesures.

Suivant un autre aspect, il est proprosé un système de détection et/ou de mesure de position d'objets comprenant une pluralité d'électrodes capacitives et au moins un dispositif de mesure capacitive selon l'invention.

Lorsque plusieurs dispositifs de mesure capacitive sont mis en oeuvre, ils peuvent être configurés en mode maître-esclave.

Le système peut comprendre des électrodes transparentes disposées sur un écran d'affichage.

Un dispositif selon l'invention peut être mis en oeuvre ou utilisé dans tous types d'applications de mesure capacitive.

Suivant encore un autre aspect, il est proposé une utilisation d'au moins un dispositif selon l'invention dans l'une quelconque des applications suivantes :
- interface homme-machine tactile et/ou sans contact,
- système de mesure dimensionnelle,
- système anticollision,
- détecteur de proximité.

Un dispositif selon l'invention peut ainsi par exemple être utilisé pour réaliser un système de mesure capacitif compact, ou pour piloter une antenne de détection capacitive de la position d'un patient dans un système d'imagerie médicale.

### Description des figures et modes de réalisation

D'autres avantages et particularités de l'invention apparaîtront à la lecture de la description détaillée de mises en oeuvre et de modes de réalisation nullement limitatifs, et des dessins annexés suivants :
- la figure 1 illustre un schéma électrique général de dispositif de mesure capacitive selon l'invention,
- la figure 2 illustre un mode de réalisation de dispositif de mesure capacitive sous la forme d'un circuit intégré comprenant deux puces séparées dans un même boîtier,
- la figure 3 illustre une disposition interne de dispositif de mesure capacitive réalisé sous la forme d'un circuit intégré comprenant deux puces séparées dans un même boîtier,
- la figure 4 illustre un mode de réalisation de dispositif de mesure capacitive sous la forme d'un circuit intégré comprenant une seule puce,
- la figure 5 illustre une disposition interne de dispositif de mesure capacitive réalisé sous la forme d'un circuit intégré comprenant une seule puce,
- la figure 6 illustre un exemple de mode de réalisation de dispositif selon l'invention dans une technologie CMOS,
- la figure 7 illustre une répartition des niveaux de potentiels électriques dans l'exemple de mode de réalisation de dispositif selon l'invention dans une technologie CMOS,
- la figure 8 illustre l'implantation d'un dispositif selon l'invention réalisé sous la forme d'un circuit intégré.

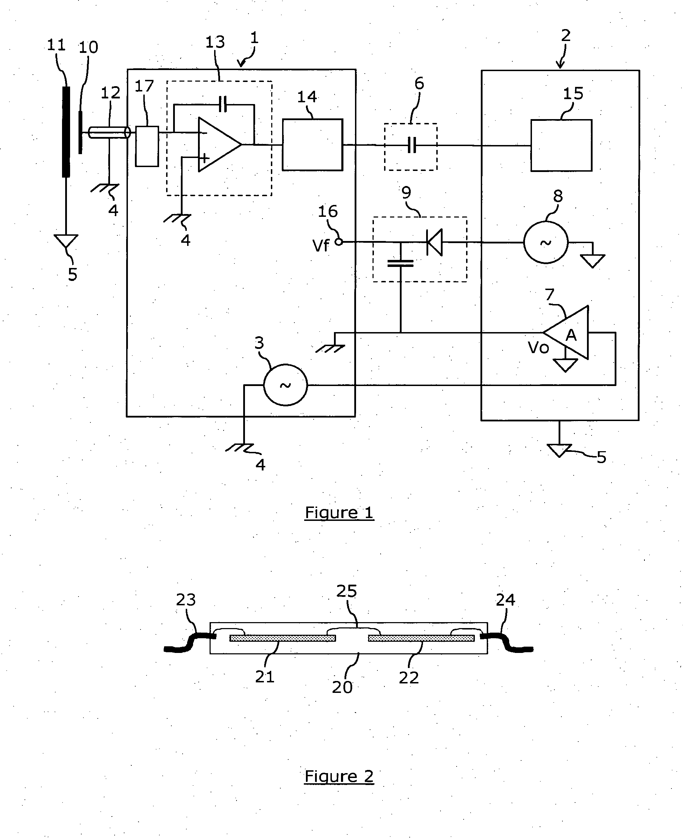

En référence à la figure 1, nous allons tout d'abord décrire un schéma électrique général de dispositif de mesure capacitive selon l'invention.

Le dispositif de mesure capacitive selon l'invention est basé sur une configuration en pont flottant tel que décrit dans le document FR 2 756 048. La figure 1 en est une illustration très schématique, étant entendu que les différentes configurations de mesure décrites dans FR 2 756 048 sont applicables dans le cadre de l'invention.

Un tel système de mesure capacitive permet de mesurer une information de capacité entre au moins une électrode de mesure 10 et une cible 11 à un potentiel relié au potentiel de masse 5.

L'électronique comprend un premier système électronique d'acquisition 1 référencé à un potentiel de garde 4 oscillant par rapport au potentiel de masse 5, et un second système électronique de traitement (ou de transfert) 2 référencé au potentiel de masse 5. Bien entendu, les dénominations des systèmes électroniques sont choisies pour la clarté de l'exposé, sans aucun effet limitatif. Le système électronique d'acquisition 1 peut en particulier comprendre des moyens de traitement de signal, y compris numériques. Le système électronique de traitement 2 peut être limité à des fonctions d'interface avec le reste de l'électronique.

Le dispositif comprend en outre des moyens d'excitation 3, 7 reliés respectivement aux potentiels de garde 4 et de masse 5. Ces moyens d'excitation ont pour fonction d'imposer entre ces potentiels 4, 5 une différence de tension alternative, faisant ainsi « flotter » l'un des potentiels de référence par rapport à l'autre.

Dans FR 2 756 048, ces moyens d'excitation comprennent essentiellement un oscillateur 3, référencé au potentiel de garde 4, et comprenant une sortie reliée au potentiel de masse 5.

Du point de vue de la génération de la tension d'excitation, l'oscillateur 3 peut être indifféremment référencé au potentiel de garde 4 ou au potentiel de masse 5. Toutefois, dans la mesure où il est également utilisé pour générer un signal d'excitation sur les électrodes 10 notamment, il doit de préférence être référencé plutôt au potentiel de garde 4.

L'oscillateur 3 tel que mis en oeuvre dans FR 2 756 048 doit consommer une puissance électrique non négligeable afin de maintenir la différence de potentiel alternative entre les potentiels de référence 4, 5. Or, comme expliqué précédemment, la puissance électrique est plus facilement disponible du côté référencé au potentiel de masse 5.

Pour cette raison, dans le dispositif selon l'invention les moyens d'excitation sont répartis différemment. Ils comprennent un oscillateur 3 référencé au potentiel de garde 4. Cet oscillateur génère un signal alternatif qui est utilisable comme signal d'excitation ou d'horloge dans le système électronique d'acquisition 1. Ce signal peut être de toute forme (par exemple sinusoïdal, carré, ou triangulaire) en fonction des applications.

Le dispositif selon l'invention comprend également un buffer 7 référencé au potentiel de masse 5. Ce buffer 7 comprend un amplificateur ou un suiveur de tension (à gain unitaire) réalisé sur la base de transistors agencés sous la forme d'amplificateur(s) opérationnels). La sortie de l'oscillateur 3 est reliée à l'entrée du buffer 7. La sortie du buffer 7 est reliée au potentiel de garde 4.

Le buffer 7 délivre en sortie un signal d'excitation **Vo**. Comme sa référence électrique interne (ou celle de son alimentation) est le potentiel de masse 5, il se comporte comme une source de tension délivrant un signal **Vo** ou en d'autres termes générant une différence de tension alternative **Vo** entre la masse 5 et le potentiel de garde 4.

En procédant de cette manière, on obtient les avantages d'un oscillateur 3 référencé au potentiel de garde 4, mais dont la consommation électrique est minimisée puisque l'essentiel de la puissance nécessaire à l'excitation du potentiel de garde 4 est fournie par le buffer 7 qui est référencé, donc alimenté par la partie au potentiel de masse 5.

Le système électronique d'acquisition 1 est entièrement référencé au potentiel de garde 4 pour éviter l'apparition de capacités parasites entre les électrodes de mesures 10 ou d'autres parties sensibles et le potentiel de masse 5, auquel est relié la cible ou l'objet détecté 11. De même, des électrodes de garde 12 protègent les électrodes de mesure 10. Etant au même potentiel que ces dernières, elles évitent également l'apparition de capacités parasites.

Les électrodes de mesure 10 sont reliées à un amplificateur de charge 13 qui permet d'en mesurer la capacité. La figure 1 montre une représentation très schématique de l'amplificateur de charges 13, qui peut être réalisé sous toutes formes, dont celles décrites dans FR 2 756 048. L'amplificateur de charge 13 peut en particulier être réalisé sous la forme d'un système en boucle fermée, utilisant le signal de l'oscillateur 3 dont l'amplitude peut être modulée, pour mesurer par une méthode de zéro une capacité ou une inverse de capacité.

Suivant les applications, le système électronique d'acquisition 1 peut comprendre des étages de traitement du signal 14, afin par exemple de délivrer un signal représentatif d'une distance entre les électrodes de mesure 10 et la cible 11.

Le système est en général conçu pour « lire » une pluralité d'électrodes 10 de toutes géométries. Il comprend alors un scrutateur 17 inséré entre les électrodes 10 et l'amplificateur de charge 13, et permettant de mesurer séquentiellement la capacité de ces électrodes 10. Ce scrutateur 17 peut prendre la forme d'une série de commutateurs analogiques référencés au potentiel de garde 4, et commandés par une électronique de contrôle.

Le dispositif selon l'invention permet notamment de réaliser des interfaces tactiles ou sans contact pour des appareils tels que des téléphones portables (smartphones) des tablettes ou des ordinateurs. Les électrodes 10 peuvent être des électrodes transparentes, par exemple en ITO (oxyde d'indium dopé à l'étain), déposées sur un écran d'affichage ou une dalle tactile. Elles sont alors utilisées pour détecter l'approche et/ou le contact d'un objet de commande 11 tel qu'un doigt.

Le dispositif selon l'invention comprend également un système électronique de traitement 2 référencé électriquement à un potentiel de masse 5. Ce système électronique de traitement 2 assure également la fonction d'interface entre le dispositif selon l'invention et le reste de l'électronique (à l'exclusion bien entendu des électrodes 10). Cela permet de réaliser un dispositif selon l'invention essentiellement sous la forme d'un circuit intégré globalement référencé au potentiel de masse 5, et alimenté par des sources d'alimentation référencées au potentiel de masse 5.

Le système électronique de traitement 2 est relié au système électronique d'acquisition 1 par des moyens de liaison 6 qui permettent de faire transiter les signaux numériques ou analogiques. Ces moyens de liaison 6 comprennent des liaisons électriques pourvues de moyens de découplage pour assurer une isolation entre les potentiels de masse et de garde, au moins dans une gamme de fréquence. On utilise de préférence dans le cadre de l'invention des capacités comme moyens de découplage, car elles sont facilement intégrables et permettent le transfert de signaux au moins à fréquences élevées (par exemple numériques).

Le dispositif selon l'invention peut être synchronisé avec d'autres dispositifs selon l'invention ou d'autres dispositifs compatibles afin de contrôler un plus grand nombre d'électrodes 10 que ce qui est faisable avec un seul dispositif.

Pour cela, les dispositifs sont configurés respectivement suivant un mode maître ou esclave, par exemple grâce à des fonctions logiques internes, de telle sorte à :
- relier les potentiels de garde 4 de tous les dispositifs,
- désactiver l'oscillateur 3 et le buffer 7 des dispositifs configurés en mode esclave,
- transmettre la sortie de l'oscillateur 3 et la sortie du buffer 7 d'un dispositif configuré en mode maître aux dispositifs configurés en mode esclave.

Suivant une variante, si les gains des buffers 7 des différents dispositifs sont suffisamment homogènes, la configuration suivante peut être utilisée :
- désactiver l'oscillateur 3 des dispositifs configurés en mode esclave,
- transmettre la sortie de l'oscillateur 3 d'un dispositif configuré en mode maître aux dispositifs configurés en mode esclave, et utiliser pour chaque dispositif esclave son buffer 7.

Dans le but de réaliser un dispositif selon l'invention essentiellement sous la forme d'un circuit intégré globalement référencé au potentiel de masse 5, il est nécessaire de générer également, dans ce dispositif, des alimentations référencées au potentiel de garde 4. En outre, ces alimentations doivent être réalisées avec des composants facilement intégrables.

Dans le mode de réalisation présenté à la figure 1, le dispositif selon l'invention comprend donc au moins une source d'alimentation **Vf** référencée au potentiel de garde 4, qui comprend une source de tension d'alimentation alternative 8 référencée au potentiel de masse 5, et des moyens de redressement et de filtrage 9.

Les moyens de redressement et de filtrage 9 sont reliés en entrée respectivement à la source de tension d'alimentation alternative 8 et au potentiel de garde 4. Ils comprennent, selon l'exemple de mise en oeuvre nullement limitatif de la figure 1, une diode de redressement reliée à la source de tension d'alimentation alternative 8 et une capacité de filtrage en parallèle sur la sortie 16 de l'alimentation **Vf** référencée au potentiel de garde 4. Cette capacité de filtrage peut également être une capacité équivalente, due à une impédance d'entrée d'un composant.

Pour qu'un tel schéma fonctionne, il faut un trajet de retour du courant vers la source de tension d'alimentation alternative 8. Dans le dispositif selon l'invention, ce trajet de retour s'effectue au travers de la sortie du buffer 7.

Le buffer 7 piloté par l'oscillateur 3 permet en effet de réaliser un retour du circuit d'alimentation par une liaison entre le potentiel de garde 4 et le potentiel de masse 5, sans court-circuiter ces potentiels de référence aux fréquences du signal d'excitation de l'oscillateur 3. Cet effet est obtenu comme expliqué précédemment grâce au fonctionnement en générateur de Thévenin du buffer 7 piloté par l'oscillateur 3, qui impose le signal d'excitation entre les potentiels de garde 4 et de masse 5, tout en ayant une impédance faible.

La source d'alimentation **Vf** peut en particulier être utilisée pour alimenter l'oscillateur 3, et, par exemple, l'amplificateur de charge 13.

En référence à la figure 2, suivant un premier mode de réalisation, le dispositif selon l'invention comprend un circuit intégré 20 qui comprend lui-même deux puces distinctes 21, 22 intégrées dans un même boîtier.

Le circuit intégré 20 est, sans perte de généralité, de type CMS (composants à montage de surface), avec des pattes 23, 24 aptes à être soudées sur un circuit imprimé.

Le système électronique d'acquisition 1 référencé au potentiel de garde 4 est implémentée sous la forme d'une première zone d'implantation, ou zone d'acquisition 38 dans une première puce 21, et le système électronique de traitement 2 référencé au potentiel de masse 5 est implémentée sous la forme d'une seconde zone d'implantation, ou zone de traitement 39 dans une seconde puce 22.

L'avantage de ce mode de réalisation est de simplifier considérablement la réalisation des puces 21, 22, qui ne comprennent chacune qu'un seul potentiel de référence.

Les puces 21, 22 sont reliées par des fils de liaison 25 internes selon des techniques classiques de « bonding ».

La puce 21, référencée au potentiel de garde 4, est reliée aux électrodes de mesure 10 et aux autres éléments référencés à la garde par un premier ensemble de pattes 23 du circuit intégré 20.

La puce 22, référencée au potentiel de masse 5, est reliée aux autres éléments de l'électronique par un second ensemble de pattes 24 du circuit intégré 20.

Les pattes 23, 24 et les fils de liaison internes 25 sont disposés de telle sorte que les liaisons avec des parties sensibles référencées au potentiel de garde 4, et notamment les liaisons avec les électrodes 10, ne soient environnées que de liaisons référencées à la garde 4.

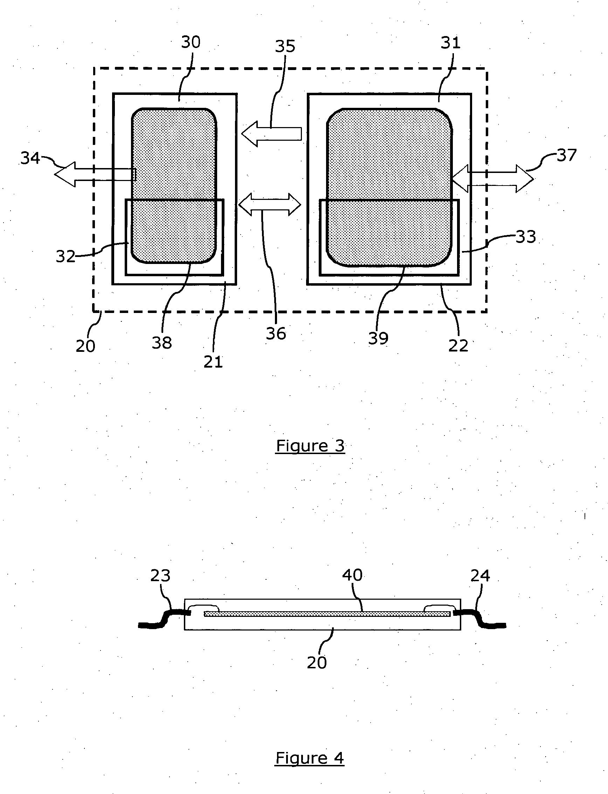

La figure 3 présente un exemple d'implantation du mode de réalisation avec des puces 21, 22 séparées sous la forme d'ASICs (circuits intégrés spécialisés « Application-Specific Integrated Circuit ») réalisés en technologie CMOS.

La puce 21 comprend notamment deux plans d'alimentation 30, 32, dont le substrat 30, référencés ou reliés au potentiel de garde 4, et une zone d'acquisition 38 dans laquelle est implémenté le système électronique d'acquisition 1.

La puce 22 comprend notamment deux plans d'alimentation 31, 33, dont le substrat 31, référencés ou reliés au potentiel de masse 5, et une zone de traitement 39 dans laquelle est implémenté le système électronique de traitement 2.

Les liaisons 29 entre les puces 21, 22 incluent les transferts d'alimentation 35 vers la zone d'acquisition 38 et les transferts de données 36 entre les zones d'acquisition 35 et de traitement 39.

Suivant une variante, la puce 22 comprenant le système électronique de traitement 2 peut être réalisée avec un FPGA (circuit logique programmable).

En référence à la figure 4, suivant un second mode de réalisation, le dispositif selon l'invention comprendre un circuit intégré 20 qui comprend une seule puce 40.

Le circuit intégré 20 est, sans perte de généralité, de type CMS (composants à montage de surface), avec des pattes 23, 24 aptes à être soudées sur un circuit imprimé.

Les pattes 23, 24 sont disposées de telle sorte que les liaisons avec des parties sensibles référencées au potentiel de garde 4, et notamment les liaisons avec les électrodes 10, ne soient environnées que de liaisons référencées à la garde 4.

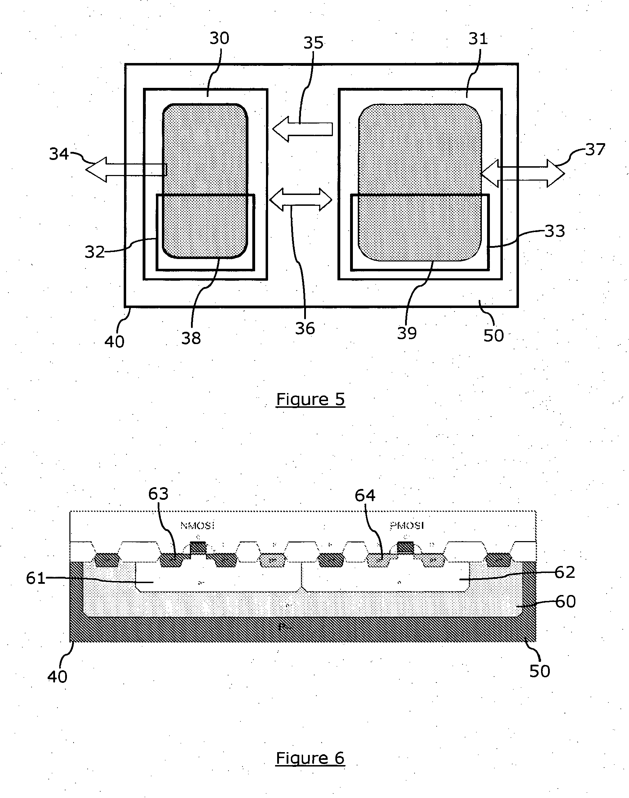

La figure 5 présente un exemple d'implantation de ce mode de réalisation de la puce 40 sous la forme d'un circuit intégré ou d'un ASIC (circuit intégré spécialisé, « Application-Specific Integrated Circuit») réalisé en technologie CMOS.

Les zones d'acquisition 38 référencée au potentiel de garde 4, et de traitement 39 référencée au potentiel de masse 5, sont réalisées dans la même puce 40.

Le substrat 50 de la puce 40 est relié au potentiel de garde. Cette configuration a l'avantage de générer un plan de garde qui couvre la totalité des zones d'acquisition 38 et de référence 39, et permet de réduire significativement la sensibilité aux capacités parasites.

La zone d'acquisition 38 est environnée par des plans d'alimentation 30, 32, référencés ou reliés au potentiel de garde 4.

La zone de traitement 39 est environnée par des plans d'alimentation 31, 33, référencés ou reliés au potentiel de masse 5.

Les transferts d'alimentation 35 vers la zone d'acquisition 38 et les transferts de données 36 entre les zones d'acquisition 35 et de traitement 39 sont réalisés sur la puce 40.

En référence à la figure 6, la puce 40 est réalisée en technologie CMOS selon une technique à trois caissons. Elle comprend :
- un premier caisson 50 de dopage P, correspondant au substrat 50, qui est relié est au potentiel de garde 4.
- un second caisson 60 de dopage N,
- un troisième caisson 61 de dopage P et un troisième caisson 62 de dopage N, inclus dans le second caisson 60 et comprenant les composants 63, 64 des zones d'acquisition 38 et de référence 39.

L'isolation électrique nécessaire au bon fonctionnement de l'ensemble peut être obtenue en polarisant en sens inverse des jonctions P-N afin de les bloquer. Pour cela, il faut respecter des relations particulières entre les tensions de référence 4, 5 et d'alimentation des différentes parties.

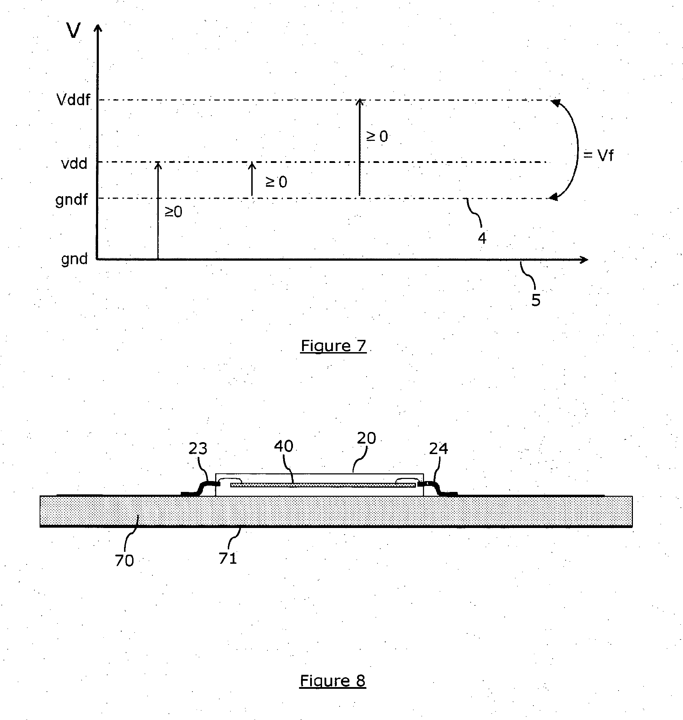

La figure 7 illustre les niveaux de tension à prendre en compte.

On définit : **gnd** le potentiel de référence de la masse 5 ; **vdd** le niveau de tension de l'alimentation référencée à la masse 5 ; **gndf** le potentiel de référence de garde 4; et **vddf** le niveau de tension de l'alimentation référencée au potentiel de garde 4.

Conformément à la figure 7, on impose les conditions suivantes :
(i) **vdd ≥ gnd,**
(ii) **vdd ≥ gndf** à tout instant car **gndf** est un potentiel oscillant relativement à **vdd,**
(iii) **vddf ≥ gndf,** sachant que **vddf - gndf** = **Vf**, une tension d'alimentation référencée au potentiel de garde 4;

Sur la base de ces conditions, les potentiels des caissons peuvent être répartis de la façon suivante :
- substrat 50 de dopage P au potentiel **gndf**, soit au potentiel de garde 4,
- second caisson 60 et troisième caisson 62 de dopage N au potentiel **vddg**, avec les transistors 64 du caisson 62 au potentiel **gnd**, ce qui permet d'avoir des jonctions bloquées par défaut,
- troisième caisson 61 de dopage P au potentiel **gndf**, avec les transistors 63 du caisson 61 au potentiel **vddf**, ce qui permet d'avoir des jonctions bloquées par défaut.

Dans cette configuration, la zone d'acquisition 38 référencée au potentiel de garde 4 est implémentée dans le caisson 61, et la zone de traitement 39 référencée au potentiel de masse 5 est implémentée dans le caisson 62.

Les potentiels peuvent également être répartis de la façon suivante, qui est sensiblement équivalente :
- substrat 50 de dopage P au potentiel **gndf**, soit au potentiel de garde 4,
- second caisson 60 et troisième caisson 62 de dopage N au potentiel **vddf**, avec les transistors 64 du caisson 62 au potentiel **gndf**, ce qui permet d'avoir des jonctions bloquées par défaut,
- troisième caisson 61 de dopage P au potentiel **gnd**, avec les transistors 63 du caisson 61 au potentiel **vdd**, ce qui permet d'avoir des jonctions bloquées par défaut.

Dans cette configuration, la zone d'acquisition 38 référencée au potentiel de garde 4 est implémentée dans le caisson 62, et la zone de traitement 39 référencée au potentiel de masse 5 est implémentée dans le caisson 61.

En référence à la figure 8, le dispositif selon l'invention peut avantageusement être complété par un plan de blindage 71 au potentiel de garde 4 placé par exemple sur la face opposée du circuit imprimé 70 sur lequel est soudé le circuit intégré.

Suivant des variantes,
- le circuit intégré 20 peut comprendre tous types de boîtiers, dont par exemple un boîtier à connexions latérales avec des broches 23, 24 disposées sur les côtés, ou un boîtier à connexions matricielles avec des broches disposées en matrice sous le boîtier ;
- les puces 21, 22 ou 40 peuvent être reliées au boîtier par des fils, ou par des billes de soudure (« ball bounded »),
- le circuit intégré 20 peut être réalisé selon des techniques de « flip chip », selon lesquelles les puces sont directement reliés au circuit imprimé, sans boîtier intermédiaire,
- des puces 20, 21 peuvent être assemblées par des techniques d'assemblage 3D (« chip level packaging »).

Bien sûr, l'invention n'est pas limitée aux exemples qui viennent d'être décrits et de nombreux aménagements peuvent être apportés à ces exemples sans sortir du cadre de l'invention.

## Revendications

1. Dispositif de mesure capacitive comprenant :
- un premier système électronique (1), référencé électriquement à un potentiel de garde (4), et apte à être relié à des électrodes capacitives (11),
- un second système électronique (2), référencé électriquement à un potentiel de masse (5), et relié audit premier système électronique (1) par des moyens de liaison (6), et
- des moyens d'excitation (3, 7) reliés respectivement auxdits potentiels de garde (4) et de masse (5) de telle sorte à imposer entre ces potentiels (4, 5) une différence de tension alternative,
**caractérisé en ce qu'**il comprend en outre un circuit intégré (20), référencé à la masse, comprenant :
- une première zone d'implantation (38), référencée au potentiel de garde (4) et dans laquelle est implémenté ledit premier système électronique (1), et
- une seconde zone d'implantation (39), référencée au potentiel de masse (5), et dans laquelle est implémenté ledit second système électronique (2).

2. Dispositif selon la revendication 1, **caractérisé en ce qu'**il comprend en outre une surface de blindage (50, 71) électriquement reliée au potentiel de garde (4), et disposée de telle sorte à couvrir au moins en partie et au moins selon un côté la surface de la première zone d'implantation (38).

3. Dispositif selon l'une des revendications 1 ou 2, **caractérisé en ce qu'**il comprend en outre une surface de blindage (50, 71) électriquement reliée au potentiel de garde (4), et disposée de telle sorte à couvrir au moins en partie et au moins selon un côté la surface des première et seconde zones d'implantation (38, 39).

4. Dispositif selon l'une des revendications précédentes, **caractérisé en ce que** le circuit intégré (20) comporte deux puces distinctes (21, 22) comprenant respectivement les première et seconde zones d'implantation (38, 39), intégrées dans un même boîtier (20).

5. Dispositif selon l'une des revendications précédentes, **caractérisé en ce que** le circuit intégré (20) comporte une puce (40) comprenant sur un même substrat les première et seconde zones d'implantation (38, 39).

6. Dispositif selon l'une des revendications précédentes, **caractérisé en ce que** le circuit intégré (20) comporte au moins une puce (21, 22, 40) réalisée en mettant en oeuvre au moins l'une des technologies suivantes : CMOS, silicium sur isolant (SOI).

7. Dispositif selon la revendication 5, **caractérisé en ce que** la puce (40) est réalisée en mettant en oeuvre une technologie CMOS à caissons multiples,

8. Dispositif selon la revendication 7, **caractérisé en ce que** la puce (40) est réalisée en mettant en oeuvre une technologie CMOS à triples caissons, et comporte :
- un substrat (50) de dopage P, relié au potentiel de garde (4),
- un premier caisson (60) de dopage N,
- deux caissons (61, 62) de dopage N et P inclus dans le premier caisson (60), et correspondant chacun à l'une des première et seconde zones d'implantation (38, 39).

9. Dispositif selon l'une des revendications précédentes, **caractérisé en ce que** le circuit intégré (20) est réalisé en mettant en oeuvre au moins l'une des technologies suivantes :
- assemblage d'une puce ou de plusieurs puces juxtaposées dans un boîtier,
- empilement en 3D de puces (« chip level-packaging »),
- connexions directes de puces (« flip chip »).

10. Dispositif selon l'une des revendications précédentes, **caractérisé en ce que** le circuit intégré comprend en outre (i) des premiers éléments de connexion (23) permettant de relier le premier système électronique (1) à des électrodes capacitives (10) et/ou à des éléments au potentiel de garde (4), (ii) des seconds éléments de connexion (24) permettant d'une part de relier le second système électronique (2) à une électronique de traitement externe, et d'autre part d'alimenter ledit second système électronique (2), lesquels premiers et seconds éléments de connexion (23, 24) étant séparés par au moins un élément de connexion relié au potentiel de garde (4).

11. Dispositif selon l'une des revendications précédentes, **caractérisé en ce que** le circuit intégré comprend en outre des moyens (8, 9) pour générer au moins une alimentation (**Vf**) référencée au potentiel de garde (4).

12. Dispositif selon la revendication 11, **caractérisé en ce que** le circuit intégré comprend en outre :
- une source de tension d'alimentation alternative (8) référencée au potentiel de masse (5), dont le circuit se referme au travers des moyens d'excitation (7), et
- des moyens de redressement et de filtrage (9), reliés en entrée respectivement à ladite source de tension d'alimentation alternative (8) et au potentiel de garde (4), de telle sorte à générer en une sortie (16) une tension d'alimentation (**Vf**) référencée audit potentiel de garde (4) par redressement d'une tension aux bornes de la source de tension d'alimentation alternative (8).

13. Dispositif selon l'une quelconque des revendications précédentes, caractérisé en ce les moyens d'excitation comprennent en outre l'un des ensembles de composants suivants :
- un buffer (7) suiveur de tension, référencé au potentiel de masse (5) et excité par un oscillateur (3) référencé au potentiel de garde (4).
- un oscillateur référencé au potentiel de masse (5).

14. Dispositif selon l'une des revendications précédentes, **caractérisé en ce que** les moyens de liaison (6) comprennent des capacités en série.

15. Dispositif selon l'une des revendications précédentes, **caractérisé en ce que** le premier système électronique (1) comprend des moyens de scrutation (17) permettant d'interroger séquentiellement des électrodes capacitives (10) pour en mesurer la capacité.

16. Dispositif selon l'une des revendications précédentes, **caractérisé en ce qu'**il comprend en outre des moyens de communication avec des dispositifs similaires lui permettant de fonctionner selon un mode maître ou esclave, selon lequel :
- les moyens d'excitation (3, 7) d'un dispositif configuré en mode maître imposent une différence de tension alternative similaire entre les potentiels de garde (4) et de masse (5) de dispositifs configurés en mode esclave, et
- les moyens d'excitation (3, 7) de dispositifs configurés en mode esclave sont au moins en partie désactivés.

17. système de détection et/ou de mesure de position d'objets, **caractérisé en ce qu'**il comprend une pluralité d'électrodes capacitives (10) et au moins un dispositif de mesure capacitive selon l'une des revendications précédentes.

18. Système selon la revendication 17, **caractérisé en ce qu'**il comprend des électrodes (10) transparentes disposées sur un écran d'affichage.

19. Utilisation d'au moins un dispositif selon l'une des revendications 1 à 16 dans l'une quelconque des applications suivantes :
- interface homme-machine tactile et/ou sans contact,
- système de mesure dimensionnelle,
- système anticollision,
- détecteur de proximité.

## Patentansprüche

1. Kapazitive Messvorrichtung, umfassend:
- ein erstes elektronisches System (1), auf ein Schutzpotenzial (4) elektrisch bezogen und dazu geeignet, mit kapazitiven Elektroden (11) verbunden zu werden,
- ein zweites elektronisches System (2), auf ein Massepotenzial (5) elektrisch bezogen und mit dem genannten, ersten elektronischen System (1) über Verbindungsmittel (6) verbunden, und
- Erregungseinrichtungen (3, 7), jeweils mit den genannten Schutz- (4) und Massepotenzialen (5) derart verbunden, dass zwischen diesen Potenzialen (4, 5) ein Wechselspannungsunterschied erzwungen wird,
**dadurch gekennzeichnet, dass** sie außerdem einen integrierten, auf die Masse bezogenen Schaltkreis (20) umfasst, umfassend:
- einen ersten, auf das Schutzpotenzial (4) bezogenen Anordnungsbereich (38), in welchem das genannte erste elektronische System (1) implementiert ist, und
- einen zweiten, auf das Massepotenzial (5) bezogenen Anordnungsbereich (39), in welchem das genannte zweite elektronische System (2) implementiert ist.

2. Vorrichtung nach Anspruch 1, **dadurch gekennzeichnet, dass** sie außerdem eine mit dem Schutzpotenzial (4) elektrisch verbundene Abschirmoberfläche (50, 71) umfasst, welche derart gelagert ist, dass sie zumindest teilweise und zumindest einer Seite nach die Fläche des ersten Anordnungsbereichs (38) bedeckt.

3. Vorrichtung nach einem der Ansprüche 1 oder 2, **dadurch gekennzeichnet, dass** sie außerdem eine mit dem Schutzpotenzial (4) elektrisch verbundene Abschirmoberfläche (50, 71) umfasst, welche derart gelagert ist, dass sie zumindest teilweise und zumindest einer Seite nach die Fläche des ersten und des zweiten Anordnungsbereichs (38, 39) bedeckt.

4. Vorrichtung nach einem der vorhergehenden Ansprüche, **dadurch gekennzeichnet, dass** der integrierte Schaltkreis (20) zwei verschiedene Chips (21, 22) enthält, welche jeweils den ersten und den zweiten, in einem und demselben Gehäuse (20) eingebauten Anordnungsbereich (38, 39) umfasst.

5. Vorrichtung nach einem der vorhergehenden Ansprüche, **dadurch gekennzeichnet, dass** der integrierte Schaltkreis (20) einen Chip (40) enthält, welcher auf einem und demselben Substrat den ersten und den zweiten Anordnungsbereich (38, 39) umfasst.

6. Vorrichtung nach einem der vorhergehenden Ansprüche, **dadurch gekennzeichnet, dass** der integrierte Schaltkreis (20) mindestens einen Chip (21, 22, 40) enthält, welcher mit Anwendung mindestens einer der folgenden Technologien: CMOS, Silizium-auf-Isolator (SOI) gefertigt wurde.

7. Vorrichtung nach Anspruch 5, **dadurch gekennzeichnet, dass** der Chip (40) mit Anwendung einer CMOS-Technologie mit Mehrfachwannen gefertigt wurde.

8. Vorrichtung nach Anspruch 7, **dadurch gekennzeichnet, dass** der Chip (40) mit Anwendung einer CMOS-Technologie mit Dreifach-Wannen gefertigt ist, und enthaltend:
- ein Substrat (50) mit P-Dotierung, mit dem Schutzpotenzial (4) verbunden,
- eine erste Wanne (60) mit N-Dotierung,
- zwei Wannen (61, 62) mit N- und P-Dotierung, in der ersten Wanne (60) eingebettet und jeweils einem der ersten und der zweiten Anordnungsbereiche (38, 39) entsprechend.

9. Vorrichtung nach einem der vorhergehenden Ansprüche, **dadurch gekennzeichnet, dass** der integrierte Schaltkreis (20) mit Anwendung mindestens einer der folgenden Technologien realisiert ist:
- Aufbau eines Chips oder mehrerer, nebeneinander liegenden Chips in einem Gehäuse,
- 3D-Stapeln von Chips ("chip level packaging"),
- direkte Verbindungen von Chips ("flip chip").

10. Vorrichtung nach einem der vorhergehenden Ansprüche, **dadurch gekennzeichnet, dass** der integrierte Schaltkreis außerdem enthält (i) erste Verbindungselemente (23) zur Verbindung des ersten elektronischen Systems (1) mit kapazitiven Elektroden (10) und/oder mit Elementen am Schutzpotenzial (4), (ii) zweite Verbindungselemente (24) einerseits zur Verbindung des zweiten elektronischen Systems (2) mit einer externen Bearbeitungselektronik und andererseits zur Versorgung des zweiten elektronischen Systems (2), wobei jene ersten und zweiten Verbindungselemente (23, 24) durch mindestens ein mit dem Schutzotenzial (4) verbundenes Verbindungselement getrennt sind.

11. Vorrichtung nach einem der vorhergehenden Ansprüche, **dadurch gekennzeichnet, dass** der integrierte Schaltkreis außerdem Mittel (8, 9) zur Generierung mindestens einer auf das Schutzpotenzial (4) bezogenen Spannung (Vf) umfasst.

12. Vorrichtung nach Anspruch 11, **dadurch gekennzeichnet, dass** der integrierte Schaltkreis außerdem umfasst:
- eine Quelle für die auf das Massepotenzial (5) bezogene Versorgungswechselspannung (8), deren Schaltung anhand der Erregungseinrichtungen (7) wieder geschlossen wird, und
- Gleichrichten- und Filtereinrichtungen (9), am Eingang jeweils mit der genannten Quelle der Versorgungswechselspannung (8) und dem Schutzpotenzial (4) derart verbunden, dass an einem Ausgang (16) eine auf das Schutzpotenzial (4) bezogene Versorgungsspannung (**Vf**) durch Gleichrichten einer Spannung an den Polen der Versorgungswechselspannungsquelle (8) generiert wird.

13. Vorrichtung nach einem der vorhergehenden Ansprüche, **dadurch gekennzeichnet, dass** die Erregungseinrichtungen außerdem eine der Anordnungen folgender Komponenten umfassen:
- einen Mikrofonverstärker (7) als Spannungsfolger, auf das Massepotenzial (5) bezogen und durch einen auf das Schutzpotenzial (4) bezogenen Oszillator (3) erregt.
- einen auf das Massepotenzial (5) bezogenen Oszillator.

14. Vorrichtung nach einem der vorhergehenden Ansprüche, **dadurch gekennzeichnet, dass** die Verbindungsmittel (6) serielle Kapazitäten umfassen.

15. Vorrichtung nach einem der vorhergehenden Ansprüche, **dadurch gekennzeichnet, dass** das erste elektronische System (1) Abtasteinrichtungen (17) umfasst, welche die sequenzielle Abfrage von kapazitiven Elektroden (10) zur Messung deren Kapazität ermöglichen.

16. Vorrichtung nach einem der vorhergehenden Ansprüche, **dadurch gekennzeichnet, dass** sie außerdem Mittel zur Kommunikation mit ähnlichen Vorrichtungen umfasst, wodurch sie in einem Master- oder einem Slave-Modus arbeiten kann, nach welchem:
- die Erregungseinrichtungen (3, 7) einer im Master-Modus konfigurierten Vorrichtung einen ähnlichen Wechselspannungsunterschied zwischen dem Schutzpotenzial (4) und dem Massepotenzial (5) von im Slave-Modus konfigurierten Vorrichtungen erzwingen, und
- die Erregungseinrichtungen (3, 7) von im Slave-Modus konfigurierten Vorrichtungen mindestens teilweise zurückgesetzt sind.

17. System zur Erkennung und/oder zur Messung der Lage von Gegenständen, **dadurch gekennzeichnet, dass** es eine Vielzahl von kapazitiven Elektroden (10) und mindestens eine kapazitive Messvorrichtung nach einem der vorhergehenden Ansprüche umfasst.

18. System nach Anspruch 17, **dadurch gekennzeichnet, dass** es durchsichtige, auf einem Bildschirm angeordneten Elektroden (10) umfasst.

19. Verwendung mindestens einer Vorrichtung nach einem der Ansprüche 1 - 16 in einer der folgenden Anwendungen:
- taktile und/oder kontaktlose Schnittstelle Mensch/Gerät,
- System zur dimensionellen Messung,
- Kollisionswarnsystem,
- Näherungssensor.

## Claims

1. Capacitive measurement device comprising:
- a first electronic system (1), electrically referenced to a guard potential (4), and capable of being connected to capacitive electrodes (11),
- a second electronic system (2), electrically referenced to a ground potential (5), and connected to said first electronic system (1) by connecting means (6), and
- excitation means (3, 7) connected respectively to said guard (4) and ground (5) potentials so as to impose an AC voltage difference between these potentials (4, 5),
**characterized in that** it comprises moreover an integrated circuit (20), referenced to the ground, comprising:
- a first installation area (38), referenced to the guard potential (4) and in which said first electronic system (1) is implemented, and
- a second installation area (39), referenced to the ground potential (5), and in which said second electronic system (2) is implemented.

2. Device according to claim 1, **characterized in that** it comprises moreover a shielding surface (50, 71) electrically connected to the guard potential (4), and arranged so as to cover the surface of the first installation area (38) at least partially and at least along one side.

3. Device according to one of claims 1 or 2, **characterized in that** it comprises moreover a shielding surface (50, 71) electrically connected to the guard potential (4), and arranged so as to cover the surface of the first and second installation areas (38, 39) at least partially and at least along one side.

4. Device according to one of the preceding claims, **characterized in that** the integrated circuit (20) comprises two distinct chips (21, 22) comprising respectively the first and second installation areas (38, 39), integrated in the same package (20).

5. Device according to one of the preceding claims, **characterized in that** the integrated circuit (20) comprises a chip (40) comprising the first and second installation areas (38, 39) on the same substrate.

6. Device according to one of the preceding claims, **characterized in that** the integrated circuit (20) comprises at least one chip (21, 22, 40) produced by implementing at least one of the following technologies: CMOS, silicon on insulator (SOI).

7. Device according to claim 5, **characterized in that** the chip (40) is produced by implementing a multiple-well CMOS technology.

8. Device according to claim 7, **characterized in that** the chip (40) is produced by implementing a triple-well CMOS technology, and comprises:
- a P-doped substrate (50), connected to the guard potential (4),
- a first N-doped well (60),
- two N- and P-doped wells (61, 62) included in the first well (60), and each corresponding to one of the first and second installation areas (38, 39).

9. Device according to one of the preceding claims, **characterized in that** the integrated circuit (20) is produced by implementing at least one of the following technologies:
- assembling one or more juxtaposed chips in a package,
- 3D stacking of chips ("chip level packaging"),
- direct connections of chips ("flip chip").

10. Device according to one of the preceding claims, **characterized in that** the integrated circuit comprises moreover (i) first connection elements (23) making it possible to connect the first electronic system (1) to capacitive electrodes (10) and/or to elements at the guard potential (4), (ii) second connection elements (24) making it possible on the one hand to connect the second electronic system (2) to external processing electronics, and on the other hand to supply said second electronic system (2), said first and second connection elements (23, 24) being separated by at least one connection element connected to the guard potential (4).

11. Device according to one of the preceding claims, **characterized in that** the integrated circuit comprises moreover means (8, 9) for generating at least a supply (**Vf**) referenced to the guard potential (4).

12. Device according to claim 11, **characterized in that** the integrated circuit comprises moreover:
- an AC supply voltage source (8) referenced to the ground potential (5), the circuit of which closes through excitation means (7), and
- rectifying and filtering means (9), connected at their input respectively to said AC supply voltage source (8) and to the guard potential (4), so as to generate at an outlet (16) a supply voltage (**Vf**) referenced to said guard potential (4) by rectification of a voltage at the terminals of the AC supply voltage source (8).

13. Device according to any one of the preceding claims, **characterized in** this the excitation means comprise moreover one of the following sets of components:
- a voltage follower buffer (7), referenced to the ground potential (5) and energized by an oscillator (3) referenced to the guard potential (4).
- an oscillator referenced to the ground potential (5).

14. Device according to one of the preceding claims, **characterized in that** the connecting means (6) comprise capacitors in series

15. Device according to one of the preceding claims, **characterized in that** the first electronic system (1) comprises scanning means (17) making it possible to poll the capacitive electrodes (10) sequentially in order to measure the capacitance thereof.

16. Device according to one of the preceding claims, **characterized in that** it comprises moreover means of communication with similar devices, allowing it to operate in a master or slave mode, according to which:
- the excitation means (3, 7) of a device configured in master mode imposes a similar AC voltage difference between the guard (4) and ground (5) potentials of devices configured in slave mode, and
- the excitation means (3, 7) of devices configured in slave mode are at least partially deactivated.

17. System for the detection and/or measurement of the position of objects, **characterized in that** it comprises a plurality of capacitive electrodes (10) and at least one capacitive measurement device according to one of the preceding claims.

18. System according to claim 17, **characterized in that** it comprises transparent electrodes (10) arranged on a display screen.

19. Use of at least one device according to one of claims 1 to 16 in any one of the following applications:
- human-machine touch and/or contactless interface ,
- dimensional measurement system,
- anti-collision system,
- proximity detector.
